# EUROPEAN PATENT APPLICATION

(11) **EP 4 749 922 A1**
(43) Date of publication of application: **27.05.2026**
(21) Application number: 25213624.7
(22) Date of filing: 05.11.2025
(51) Int. Cl.: H03K 5/131, H03K 5/26

(54) **SYSTEM AND METHOD FOR DATA TRANSMISSION**

(30) Priority: 25.11.2024 US 202463724844 P; 09.06.2025 US 202519232856
(71) Applicant: Samsung Electronics Co., Ltd., Suwon-si, Gyeonggi-do 16677 (KR)
(72) Inventor: PARK, Joung Won, San Jose, CA, 95134 (US); KIM, Jaehyup, San Jose, CA, 95134 (US); KANG, Dae Hyun, San Jose, CA, 95134 (US)
(74) Representative: Kuhnen & Wacker Patent- und Rechtsanwaltsbüro PartG mbB

(57) **Abstract**

A system and method for data transmission. In some embodiments a system includes: a phase-testing circuit, including a difference-detecting circuit, a low-pass filter circuit, and a reference-comparison circuit. The difference-detecting circuit may be configured to produce an output signal having a duty cycle corresponding to a phase difference between a first input signal, and a second input signal. The low-pass filter circuit may be connected to an output of the difference-detecting circuit, and the reference-comparison circuit may be configured to compare an output signal of the low-pass filter circuit and a threshold.

## Description

### CROSS-REFERENCE TO RELATED APPLICATION(S)

### FIELD

One or more aspects of embodiments according to the present disclosure relate to data links, and more particularly to a phase calibrator for a data link.

### BACKGROUND

Data links may be used in various applications, such as between separately packaged devices, or between dies of a multi-chip module.

It is with respect to this general technical environment that aspects of the present disclosure are related.

The above information disclosed in this Background section is only for enhancement of understanding of the background and therefore the information discussed in this Background section does not necessarily constitute prior art.

### SUMMARY

According to an embodiment of the present disclosure, there is provided a system, including: a phase-testing circuit, including: a difference-detecting circuit; a low-pass filter circuit; and a reference-comparison circuit, the difference-detecting circuit being configured to produce an output signal having a duty cycle corresponding to a phase difference between a first input signal, and a second input signal, the low-pass filter circuit being connected to an output of the difference-detecting circuit, the reference-comparison circuit being configured to compare an output signal of the low-pass filter circuit and a threshold.

In some embodiments, the threshold is set by a programmable voltage reference circuit.

In some embodiments, the programmable voltage reference circuit includes a digital to analog converter.

In some embodiments, the system further includes a first phase interpolator and a second phase interpolator, wherein the system is configured to calibrate the first phase interpolator by: setting a phase interpolator control signal of the first phase interpolator to a first value, and adjusting the threshold.

In some embodiments, the difference-detecting circuit includes: a first AND gate having: a first input configured to receive the first input signal, and a second input configured to receive the second input signal; and a second AND gate having: a first input configured to receive a third input signal, and a second input configured to receive a fourth input signal.

In some embodiments, the difference-detecting circuit includes: a first switch, between an output of the first AND gate and the output of the difference-detecting circuit and a second switch, between an output of the second AND gate and the output of the difference-detecting circuit.

In some embodiments, the first switch is controlled by the output of the second AND gate, and the second switch is controlled by the output of the first AND gate.

In some embodiments: the difference-detecting circuit is configured to receive the first input signal through a first retiming circuit, and the difference-detecting circuit is configured to receive the second input signal through a second retiming circuit.

In some embodiments, the reference-comparison circuit includes a clocked comparator and a digital accumulator circuit.

In some embodiments, the clocked comparator is configured to generate an output corresponding to a comparison between the output of the low-pass filter circuit and the threshold.

In some embodiments, the digital accumulator circuit is configured to generate an output signal based on a plurality of bits received from the clocked comparator.

In some embodiments, the digital accumulator circuit includes: a first counter to count bits having a value of one; a second counter to count bits having value of zero; and an output circuit to generate a first output value based on the first counter reaching a threshold count or a second output value based on the second counter reaching a threshold count.

According to an embodiment of the present disclosure, there is provided a method, including: setting a first phase interpolator control signal to a first value; determining, by a phase-testing circuit, that a phase difference between an output of a first phase interpolator and an output of a second phase interpolator exceeds a threshold; setting the first phase interpolator control signal to a second value; determining, by the phase-testing circuit, that a phase difference between the output of the first phase interpolator and the output of the second phase interpolator is less than the threshold; and storing, as a calibrated control signal value corresponding to the threshold, the first value or the second value.

In some embodiments, the phase-testing circuit includes: a difference-detecting circuit; a low-pass filter circuit; and a reference-comparison circuit, the difference-detecting circuit being configured to produce an output signal having a duty cycle corresponding to a phase difference between a first input signal and a second input signal, the low-pass filter circuit being connected to the output of the difference-detecting circuit, the reference-comparison circuit being configured to compare an output signal of the low-pass filter circuit and a threshold.

In some embodiments, the threshold is set by a programmable voltage reference circuit.

In some embodiments, the programmable voltage reference circuit includes a digital to analog converter.

In some embodiments, the difference-detecting circuit implements an exclusive OR truth table.

In some embodiments, the difference-detecting circuit includes: a first AND gate having: a first input configured to receive the first input signal, and a second input configured to receive the second input signal; and a second AND gate having: a first input configured to receive a third input signal, and a second input configured to receive a fourth input signal.

In some embodiments, the difference-detecting circuit includes: a first switch, between the output of the first AND gate and the output of the difference-detecting circuit and a second switch, between the output of the second AND gate and the output of the difference-detecting circuit.

According to an embodiment of the present disclosure, there is provided a method, including: determining, by a phase-testing circuit, that a phase difference between an output of a first phase interpolator and an output of a second phase interpolator exceeds a threshold, the phase-testing circuit including: a difference-detecting circuit; a low-pass filter circuit; and a reference-comparison circuit, the difference-detecting circuit being configured to produce an output signal having a duty cycle corresponding to a phase difference between a first input signal and a second input signal, the low-pass filter circuit being connected to the output of the difference-detecting circuit, the reference-comparison circuit being configured to compare an output signal of the low-pass filter circuit and a threshold.

### BRIEF DESCRIPTION OF THE DRAWINGS

These and other features and advantages of the present disclosure will be appreciated and understood with reference to the specification, claims, and appended drawings wherein:
FIG. 1A is a block diagram of a system including a plurality of interconnected digital circuits, according to an embodiment of the present disclosure;
FIG 1B is a block diagram of two interconnected digital circuits, according to an embodiment of the present disclosure;
FIG 1C is a block diagram of a transmitter and a receiver, according to an embodiment of the present disclosure;
FIG. 2 is a circuit diagram of a phase-testing circuit, according to an embodiment of the present disclosure;
FIG. 3 is a circuit diagram of a digital accumulator, according to an embodiment of the present disclosure; and
FIG. 4 is a flow chart of a method, according to an embodiment of the present disclosure.

### DETAILED DESCRIPTION

The detailed description set forth below in connection with the appended drawings is intended as a description of aspects of some embodiments of data transmission system and method including, for example, a phase calibrator provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

In various electronic and computer systems, it may be desirable to enable components in the system, such as graphics cards, hard drives (including, for example, solid state drives (SSDs)), memory devices, network components or adaptors, or other peripheral components or devices, to communicate with each other using high-speed data transmission links. Such high-speed data links may include, for example, Universal Chiplet Interconnect Express (UCle), Peripheral Component Interconnect Express (PCIe), Knights Landing Token Interface (KTI), Ultra Path Interconnect (UPI), QuickPath Interconnect (QPI), Universal Serial Bus (USB) and the like. Such data links may enable relatively high data transmission speeds, flexibility in bandwidth allocation, simultaneous data transmission, relatively low latency, among other characteristics.

In a data link, data may be transmitted from a transmitter component or circuit (hereinafter referred to as a "transmitter") to a receiver component or circuit (hereinafter referred to as a "receiver") along with a clock signal. The clock signal, which may include two complementary signals, may be produced by two phase interpolators in the transmitter. In some systems the bitstream may carry an embedded clock. In some embodiments, the clock is transmitted separately, as a forwarded clock.

The phase interpolators may be adjusted, using feedback from the receiver, to use a phase that is half-way between a minimum phase at which data is successfully received and a maximum phase at which data is successfully received. The minimum phase at which data is successfully received and the maximum phase at which data is successfully received may be determined by the transmitter and the receiver using a process in which the phase is adjusted to the minimum and maximum points at which the error rate, as measured by the receiver, increases significantly.

The adjusting of the phase interpolator to a phase that is half-way between the minimum phase (at which data is successfully received) and the maximum phase (at which data is successfully received) may involve setting phase interpolator control signals to intermediate values that are approximately half-way between values corresponding to the minimum phase and the maximum phase; the phase corresponding to these intermediate values may however not be precisely half-way between values corresponding to the minimum phase and the maximum phase, e.g., if the phase generated by each phase interpolator is not linear with the phase interpolator control signal.

As such, in some embodiments as described in more detail below, a phase-testing circuit may be used to measure the phase difference between the phase interpolators while a first phase interpolator of the phase interpolators is set to a fixed phase, and the second phase interpolator is set to several different phase settings, by setting a phase interpolator control signal of the second phase interpolator to several different values. In this manner the second phase interpolator may be calibrated, e.g., the true phase produced for each of several values of the phase interpolator control signal may be measured, and a calibration table, in which are stored the respective phase interpolator control signal values that may be used to achieve any of a set of desired phases, may be generated and stored. The first phase interpolator may then be calibrated in a similar manner, while the second phase interpolator is set to a fixed phase.

The phase-testing circuit may be a circuit that determines whether the phase difference between the phase interpolator signals is greater or less than a threshold phase value, the threshold phase being adjustable. As such, the phase-testing circuit may be used to measure a phase difference by adjusting the threshold phase value until the output of the phase-testing circuit changes; at this point the phase difference equals (or nearly equals) the threshold phase value.

As described in more detail below, according to some embodiments, the phase-testing circuit may include (i) a difference-detecting circuit (which may calculate a function equivalent to an exclusive OR), (ii) a low-pass filter, connected to the output of the difference-detecting circuit, and (iii) a reference-comparison circuit, for determining whether the output of the low-pass filter is greater or less than a threshold (e.g., a reference voltage produced by the low-pass filter). The effect of the difference-detecting circuit may be to produce a rectangular-wave signal with a duty cycle proportional to the phase difference between the inputs of the difference-detecting circuit (the duty cycle being 0 if the input signals are identical (in which case the exclusive OR of these signals is always zero) and 100% if the input signals are 180 degrees out of phase (in which case the exclusive OR of these signals is always one)). The effect of the low-pass filter may be to generate an output signal proportional to the average (and proportional to the duty cycle) of the rectangular-wave signal. As such, the output of the low-pass filter may be proportional to the phase difference between the input signals. In some embodiments, each input signal is processed by a frequency divider, to reduce the frequency by a factor of 2 and to reduce the phase difference (for a given delay) by a factor of 2.

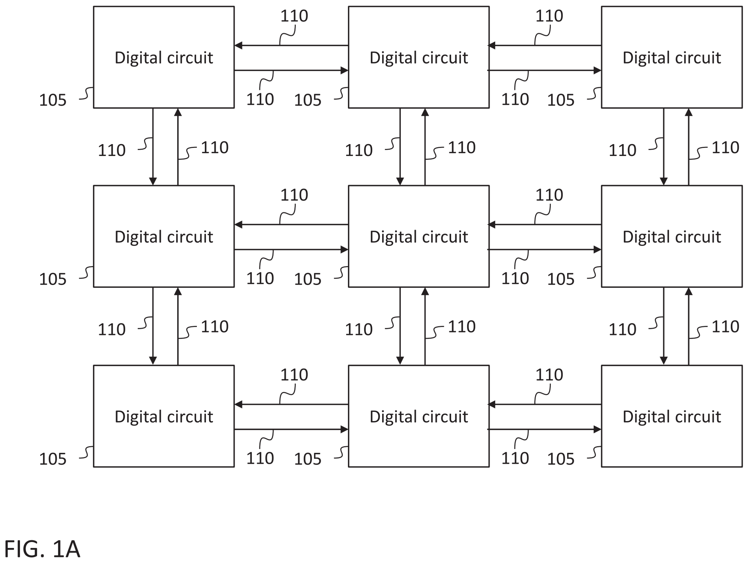

FIG. 1A shows a system-level diagram of a system including a plurality of digital circuits 105. Each of these circuits may be a single semiconductor chip (e.g., a silicon digital integrated circuit) such as a tensor flow processing unit (TPU), a central processing unit (CPU), a graphics processing unit (GPU), or a special purpose integrated circuit (e.g., a silicon application-specific integrated circuit (ASIC)), a hard drive (e.g., a solid state drive (SSD)), a memory device, a network component or adaptor, or other peripheral component or device. The digital circuits 105 may be connected by a plurality of data links 110, each of which may be a data link utilizing a data link protocol or mechanism. Such data links 110 may make it possible, for example, for the digital circuits 105 to send data (e.g., data to be processed, or data that has been processed by one or more of the digital circuits 105) to each other. For example, a first digital circuit 105 may process data it receives (e.g., from off-chip or on-chip memory) and send the result to a second digital circuit 105. Communications between the plurality of digital circuits 105 and other circuits (e.g., memory circuits for storing data to be processed) may be performed over additional data links (not shown).

In some embodiments, each of the data links 110 is a Universal Chiplet Interconnect Express (UCle) data link, although embodiments according to the present disclosure are not limited thereto, and according to various embodiments, the data links 110 may utilize other data link protocols or mechanisms. A Universal Chiplet Interconnect Express (UCle) data link may be a data link that complies with an open industry standard (the UCle standard) designed to facilitate die-to-die interconnects and communication between dies (or "chiplets") in a multi-chip module (e.g., in a multi-chip system on a chip (SoC)). UCle may be used as a universal interconnect at the package level (e.g., within the package of a multi-chip module (e.g., a multi-chip SoC)).

The UCle standard specifies a standardized die-to-die interconnect that includes the physical layer, protocol stack, software model, and compliance testing procedures. The standardization allows components produced by different manufacturers to be inter-compatible. The physical layer of UCle supports relatively fast data transfer rates (e.g., up to 32 giga bits per second (Gbps)) over multiple lanes (e.g., between 16 and 64 lanes). Like a peripheral component interconnect express (PCle) 6.0 link, a UCle link may use a 256-byte Flow Control Unit (FLIT) for data transmission. The physical specifications of the UCle standard are based on the Advanced Interface Bus (AIB) specifications; these physical specifications may result in high performance and power efficiency.

The UCle protocol layer is based on the Compute Express Link (CXL) standard and includes the CXL.io (PCle), CXL.mem, and CXL.cache protocols. A data link complying with UCle may be compatible with various interconnect technologies, including organic substrates for standard 2D packages and embedded silicon bridges (e.g., embedded multi-die interconnect bridges (EMIBs)), silicon interposers, and fanout embedded bridges. Such interconnect technologies may enhance bandwidth density and power efficiency. A data link complying with UCle may exhibit significantly higher I/O performance and lower power consumption than, for example, a PCle serializer deserializer (SerDes). For example, a data link complying with UCle may provide bandwidth density up to 1.35 TB/s per mm² for a bump pitch of 45 µm.

Data links complying with UCle may be used in various applications, including high-performance computing data centers, edge computing, and automotive and high-reliability applications. Data links complying with UCle may be suitable for high-performance computing applications, in which efficient interconnects between dies may be important. In a data center, the use of data links complying with UCle may make possible the integration of diverse dies, allowing for customized solutions.

Artificial intelligence and machine learning applications may benefit from the high bandwidth and low latency that data links complying with UCle may exhibit. By enabling efficient data transfer between dies, data links complying with UCle may make possible the rapid processing and analysis of large datasets. In edge computing, data links complying with UCle may provide a portion of the infrastructure for deploying and managing dies at the edge of a network.

In automotive and high-reliability applications, data links complying with UCle may provide runtime health monitoring and repair features (which are part of the UCle specification). These features may ensure the robustness and reliability of the data links, allowing them to be suitable for safety-critical systems. Data links complying with UCle are compatible with three-dimensional (3D) packaging, with which high packaging densities may be achieved.

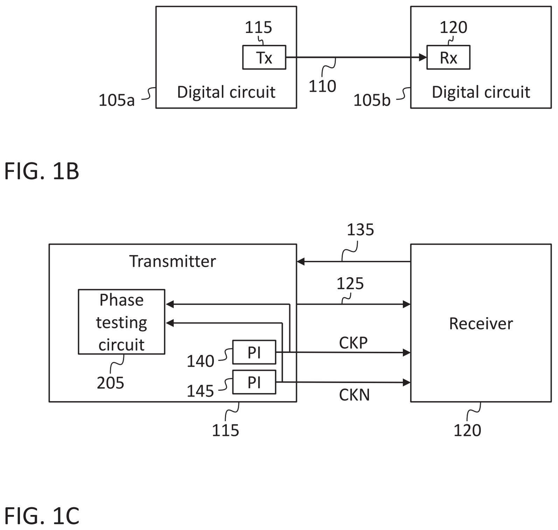

FIG. 1B shows a data link 110 between a first digital circuit 105a and a second digital circuit 105b, from among the digital circuits 105. The first digital circuit 105a includes a transmitter (Tx) (e.g., a UCle transmitter) 115 and the second digital circuit 105b includes a receiver (Rx) (e.g., a UCle receiver) 120. Although FIG. 1B illustrates the first digital circuit 105a including a transmitter 115 and the second digital circuit 105b including a receiver 120 for convenience of illustration and description, in various embodiments, each of the digital circuits may include both a transmitter and a receiver or a transceiver. The transmitter 115 may operate, for example, to convert or encode digital data from the first digital circuit 105a into a bitstream and transmit the bitstream over the physical medium (e.g., conductive wiring, optical fiber, and the like) of the data link 110 to the receiver 120 of the second digital circuit 105b.

FIG. 1C shows connections between the transmitter 115 and the receiver 120. The data link 110 may include a data channel 125 and a clock channel. As shown in FIG. 1C, two signals (CKP and CKN) of the clock signal may be generated by a first phase interpolator (PI) 140 and a second phase interpolator 145. In operation, these signals (CKP and CKN) may be separated by, e.g., 180 degrees, or 90 degrees (when transmitting in-phase (I) and quadrature (Q) clock signals). The phase of each phase interpolator 140, 145, may be controlled by a respective digital control signal (e.g., a 5-bit control signal), which may be referred to as a phase interpolator control signal (or PI code, or "PI_code").

A sideband channel 135 may be used to send feedback or control signals from the receiver 120 to the transmitter 115. In operation (e.g., at startup), the transmitter 115 may sweep the phase of the clock over a range of clock phases while sending data (e.g., a set pseudorandom bit pattern) to the receiver 120, and the receiver 120 may send, to the transmitter 115, indications of whether the data is being successfully received. The transmitter 115 may then determine the range of phase values over which the data is successfully received, and, for subsequent operation, set the operating phase to the midpoint of this range.

The setting of the operating phase to the midpoint of the range may be inaccurate if the phases of the outputs of the phase interpolators 140, 145 are not linear with the interpolator control signals. For example, setting the control signal of the first phase interpolator 140 to a value that is half-way between a first value and a second value will, if the first phase interpolator 140 is linear, result in a phase that is halfway between the phase corresponding to the first value and the phase corresponding to the second value. Such a control signal setting may however result in a different, possibly incorrect, phase if the first phase interpolator 140 is not linear. As such, each of the phase interpolators 140, 145 may be calibrated (using a system and method disclosed herein).

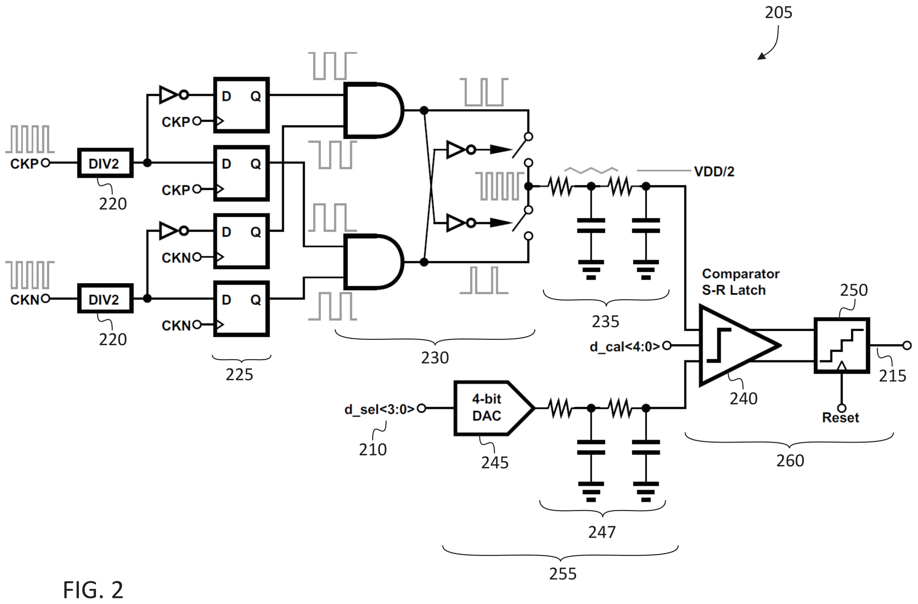

FIG. 2 shows aspects of a phase-testing circuit 205, according to some embodiments. The phase-testing circuit 205 may operate, for example, as part of a transmitter 115 (as shown in FIG. 1C), to measure the phase of the signal produced by each of the phase interpolators 140, 145 for a range of phase interpolator control signals, so as to calibrate the phase interpolators 140, 145. In some embodiments, the phase-testing circuit 205 is instead part of a receiver 120. Although FIG. 2 illustrates various components in a phase-testing circuit 205 according to some embodiments, embodiments according to the present disclosure are not limited thereto, and a phase-testing circuit 205 according to various embodiments may include additional components or fewer components without departing from the scope of embodiments according to the present disclosure.

The phase-testing circuit 205 receives (i) a first clock signal CKP at a first input, (ii) a second clock signal CKN at a second input, and (iii) a threshold signal (which it may receive from a control circuit of the transmitter 115) at a third input 210. The threshold signal may be used for setting a first phase threshold. The phase-testing circuit 205 generates a one-bit digital output signal (at the output 215) that has a first value if the phase difference between the first clock signal CKP and the second clock signal CKN is greater than the first phase threshold, and a second value if the phase difference between first clock signal CKP and the second clock signal CKN is less than the first phase threshold.

The phase-testing circuit 205 includes two frequency dividers 220, a difference-detecting circuit 230, a low-pass filter 235 connected to the output of the difference-detecting circuit 230, a programmable voltage reference 255 (or programmable voltage reference circuit) (which may include a digital-to-analog converter 245 and a low-pass filter 247), and a comparison circuit 260 including a clocked comparator 240 and a digital accumulator 250. The difference-detecting circuit 230 of FIG. 2 has four inputs, e.g., (i) a first input and a second input (which are the inputs of the upper AND gate of FIG. 2) and (ii) a third input and a fourth input (which are the inputs of the lower AND gate of FIG. 2). The difference-detecting circuit 230 determines whether the signals at the first and second input are different. Equivalently, because the signals at the third and fourth inputs are the complements of the signals at the first and second inputs, the difference-detecting circuit 230 determines whether the signals at the third and fourth inputs are different.

For example, the difference-detecting circuit 230 may calculate an exclusive OR of the outputs of the frequency dividers 220, and filter the result with a low-pass filter 235. The output of the exclusive OR may be a rectangular wave with a duty cycle that is proportional to the phase difference between the signals at the outputs of the frequency dividers 220; as such, the output of the low-pass filter 235 (e.g., the DC component of the output of the low-pass filter 235) is proportional to the phase difference between the signals at the outputs of the frequency dividers 220. The low-pass filter 235 may be a linear time-invariant circuit and it may have a corner frequency between 10^-6 F and F, where F is the clock frequency of the data link. The low-pass filter 235 may have a DC gain of about 1.0 (e.g., between 0.1 and 1.0) (as in the example illustrated in FIG. 2).

The output of the low-pass filter 235 is compared (by the comparison circuit 260) to a voltage, from the output of the programmable voltage reference circuit 255, corresponding to a second phase threshold (which, because the frequency dividers 220 reduce the phase difference (corresponding to a given delay) by a factor of 2, is half of the first phase threshold). As such, the phase testing circuit 205 determines (as mentioned above) whether the phase difference between the first clock signal CKP and the second clock signal CKN is greater or less than the first phase threshold. This capability may be used to calibrate the phase interpolators 140, 145 as discussed in further detail below. In the embodiment of FIG. 2, the combination of the programmable voltage reference circuit 255 and the comparison circuit 260 determines whether the output of the low-pass filter 235 is less than or greater than a threshold (set by the programmable voltage reference circuit 255); as such, the combination of the programmable voltage reference circuit 255 and the comparison circuit 260 may be referred to as a reference comparison circuit.

In the phase-testing circuit 205, as mentioned above, the frequency of each of the first clock signal CKP and the second clock signal CKN is divided by 2 (converted to a signal having half the frequency of the original signal) by a frequency divider 220. An inverted version of each of the resulting signals is formed, and the resulting signals are processed by a retiming stage 225 (which may include one retiming circuit (e.g., one flip flop) for each of the four signals to be retimed, as shown). The retiming circuit may synchronize the frequency-divided clock signals to the first clock signal CKP and the second clock signal CKN. The four signals are then fed to a difference-detecting circuit 230, which generates an output value of one when the outputs of the frequency dividers 220 are the same (i.e., both zero or both one) and an output value of zero when the outputs of the frequency dividers 220 are not the same (i.e., one of them is zero or and the other is one). As such, the difference-detecting circuit 230 has the effect of an exclusive OR (XOR) gate (e.g., it has the same truth table as an XOR gate) with differential inputs. While various components are illustrated as included in the difference-detecting circuit 230, some embodiments are not limited to such an implementation and any other suitable components may be used to construct a circuit to perform the functions of the difference-detecting circuit 230.

The output of the difference-detecting circuit 230 is fed to a low-pass filter 235 (e.g., a low-pass filter circuit), the output of which is fed to a first input of the comparison circuit 260, which includes a clocked comparator (e.g., a clocked comparator circuit, such as a strong-arm latch) 240 and a digital accumulator 250 (e.g., a digital accumulator circuit). The other input of the comparison circuit 260 may be fed by a reference voltage generated by the programmable voltage reference circuit 255. In the comparison circuit 260, the output of the clocked comparator 240 may be fed to a digital accumulator 250 (discussed in further detail below), which generates a digital output having a first value (e.g., one) if the difference between the phase of the first clock signal CKP and the second clock signal CKN is greater than the first phase threshold, and a second value (e.g., zero) if the phase difference between the first clock signal CKP and the second clock signal CKN is less than the first phase threshold.

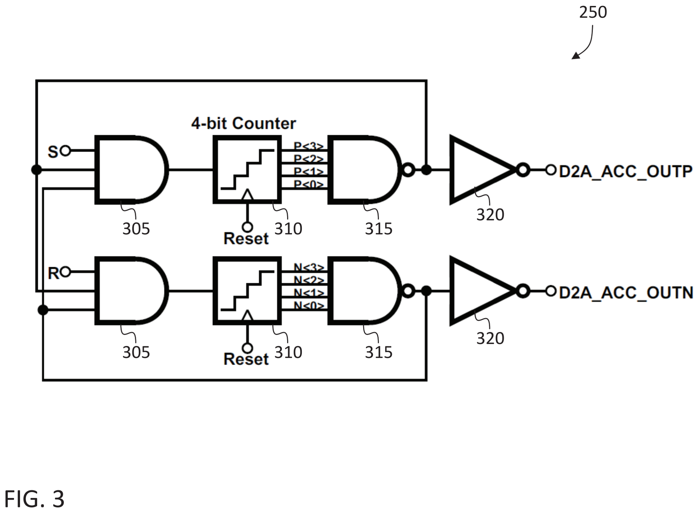

FIG. 3 shows a schematic diagram of further details of the digital accumulator 250. As shown in FIG. 3, the digital accumulator 250 may include two inputs, connected to respective outputs of the clocked comparator 240: a first input S that is high when the output of the clocked comparator 240 is high and a second input R that is high when the output of the clocked comparator 240 is low. The digital accumulator 250 includes an upper arm and a lower arm, each including an AND gate 305, a four-bit counter 310, a NAND gate 315, and an inverter 320. In operation, the four-bit counter 310 of the upper arm counts the number of clock edges during which the output of the low-pass filter 235 is greater than the output of the programmable voltage reference circuit 255, and the four-bit counter 310 of the lower arm counts the number of clock edges during which the output of the low-pass filter 235 is less than the output of the programmable voltage reference circuit 255. The four-bit counter 310 which first reaches its maximum value (in which each of the four bits has a value of one) then causes (i) the output of the NAND gate 315 connected to its outputs to transition to low (causing both counters to stop counting), and (ii) the output of the inverter 320 connected to the NAND gate to transition to high. As such, the effect of the digital accumulator 250 may be to add (e.g., accumulate) a plurality of comparator decisions (each represented by a respective bit received from the clocked comparator 240), reducing the effects of comparator noise.

Because the phase-testing circuit 205 may be used to determine whether the phase difference between first clock signal CKP and the second clock signal CKN is greater than or less than a set phase threshold, it may be used to measure (and correct for) nonlinearity in the phase produced in either of the phase interpolators 140, 145 as a function of the phase interpolator control signal it receives. For example, the first phase interpolator 140, which produces the first clock signal CKP, may be set to a fixed value (e.g., by setting a first phase interpolator control signal, which controls the first phase interpolator 140, to zero), and a second phase interpolator control signal, which controls the second phase interpolator 145, may be adjusted until the measured phase difference is 225 degrees. This may be done by setting the programmable voltage reference circuit 255 to a value corresponding to 225 degrees, and searching for two adjacent values of the phase interpolator control signal between which the output of the phase-testing circuit 205 changes. Either of these two values may then be used as the phase interpolator control signal value that, in the second phase interpolator 145, produces a phase offset corresponding to the output voltage of the programmable voltage reference circuit 255 (e.g., to 225 degrees). This process may be repeated for a plurality of settings of the programmable voltage reference circuit 255, and the second phase interpolator control signal found for each setting of the programmable voltage reference circuit 255 may be stored in a calibration table for the second phase interpolator 145, as the phase interpolator control signal value that, in the second phase interpolator 145, produces a phase offset corresponding to the setting of the programmable voltage reference circuit 255. This process may be repeated for other phase offset values, e.g., 135 degrees or 180 degrees. In some embodiments, finer phase steps (e.g., 5 degree steps) are used instead of 45 degree steps for the phase calibration. In some embodiments, only phase offsets, between the first clock signal CKP and the second clock signal CKN, that are near 180 degrees are calibrated.

Once one of the phase interpolators 140, 145 has been calibrated in this manner, the one that has been calibrated may be set to a fixed value, and the other one may be calibrated in the same manner.

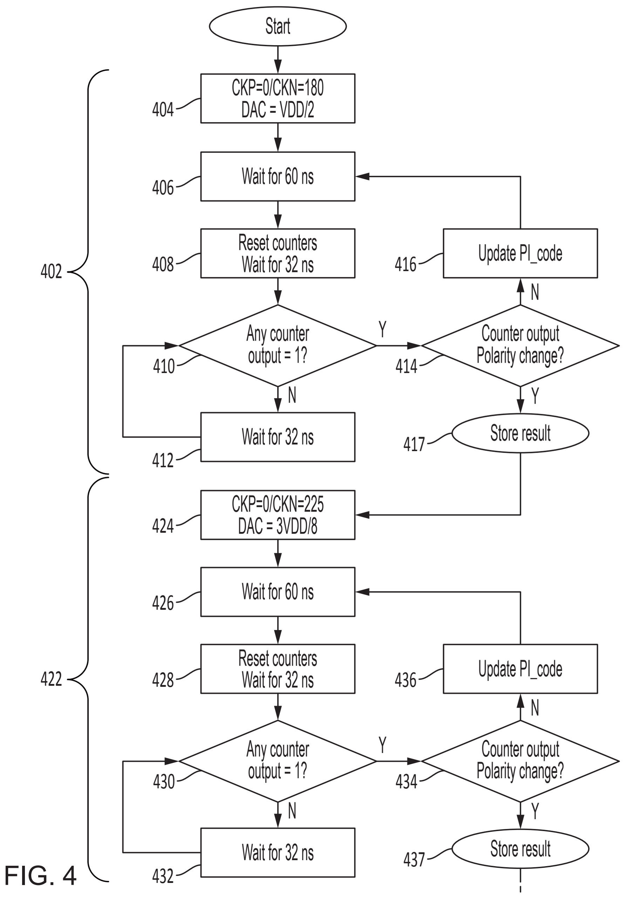

FIG. 4 shows a flow chart of a method for using the phase-testing circuit 205 to calibrate the first phase interpolator 140. Although FIG. 4 illustrates various operations in such a method, embodiments according to the present disclosure are not limited thereto. For example, according to some embodiments, such a method may include additional operations or fewer operations, or the order of operations may vary (unless otherwise explicitly stated or implied) without departing from the scope of embodiments according to the present disclosure.

In the embodiment of FIG. 4, a first calibration process 402 is used to find the second phase interpolator control signal corresponding to a phase offset of 180 degrees. At 404, the first phase interpolator control signal is set to the nominal (uncalibrated) value corresponding to 0 degrees, the second phase interpolator control signal is set to the nominal (uncalibrated) value corresponding to 180 degrees, and the programmable voltage reference circuit 255 is set to produce a voltage of VDD/2, which corresponds to a phase difference of 180 degrees. A wait operation is performed at 406, to allow the system to reach steady state, the counters of the digital accumulator 250 are reset (e.g., cleared) at 408, and at 410 and 412, the system waits until one of the counters of the digital accumulator 250 reaches its limit. At 414 the system determines whether the output of the comparison circuit 260 has changed from the value it had for the last phase interpolator control signal value tested; if it has changed, then the calibration is complete for the phase value being calibrated, and the current phase interpolator control signal value, or the last phase interpolator control signal value tested, may be stored, at 417, as a calibrated control signal value corresponding to the threshold; if it has not changed, the phase interpolator control signal value is, at 416, incremented or decremented by one.

A second calibration process 422 proceeds in a manner analogous to that shown for the first calibration process 402, for a phase difference 225 degrees. At 424, the first phase interpolator control signal is set to the nominal (uncalibrated) value corresponding to 0 degrees, the second phase interpolator control signal is set to the nominal (uncalibrated) value corresponding to 225 degrees, and the programmable voltage reference circuit 255 is set to produce a voltage of 3VDD/8, which corresponds to a phase difference of 225 degrees. A wait operation is performed at 426, to allow the system to reach steady state, the counters of the digital accumulator 250 are reset (e.g., cleared) at 428, and at 430 and 432, the system waits until one of the counters of the digital accumulator 250 reaches its limit. At 434 the system determines whether the output of the comparison circuit 260 has changed from the value it had for the last phase interpolator control signal value tested; if it has changed, then the calibration is complete for the phase value being calibrated, and the current phase interpolator control signal value, or the last phase interpolator control signal value tested, may be stored, at 437, as a calibrated control signal value corresponding to the threshold; if it has not changed, the phase interpolator control signal value is, at 436, incremented or decremented by one. The process may be performed again, in additional calibration processes (not shown in FIG. 4), e.g., for calibrating the phase interpolator control signal needed to achieve a phase difference of 135 degrees.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, when a second quantity is "within Y" of a first quantity X, it means that the second quantity is at least X-Y and the second quantity is at most X+Y. As used herein, when a second number is "within Y%" of a first number, it means that the second number is at least (1-Y/100) times the first number and the second number is at most (1+Y/100) times the first number. As used herein, the term "or" should be interpreted as "and/or", such that, for example, "A or B" means any one of "A" or "B" or "A and B".

The background provided in the Background section of the present disclosure section is included only to set context, and the content of this section is not admitted to be prior art. Any of the components or any combination of the components described (e.g., in any system diagrams included herein) may be used to perform one or more of the operations of any flow chart included herein. Further, (i) the operations are example operations, and may involve various additional steps not explicitly covered, and (ii) the temporal order of the operations may be varied.

Each of the terms "processing circuit" and "means for processing" is used herein to mean any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hard-wired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB.

As used herein, when a method (e.g., an adjustment) or a first quantity (e.g., a first variable) is referred to as being "based on" a second quantity (e.g., a second variable) it means that the second quantity is an input to the method or influences the first quantity, e.g., the second quantity may be an input (e.g., the only input, or one of several inputs) to a function that calculates the first quantity, or the first quantity may be equal to the second quantity, or the first quantity may be the same as (e.g., stored at the same location or locations in memory as) the second quantity.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the scope of the inventive concept.

The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

It will be understood that when an element or layer is referred to as being "on", "connected to", "coupled to", or "adjacent to" another element or layer, it may be directly on, connected to, coupled to, or adjacent to the other element or layer, or one or more intervening elements or layers may be present. In contrast, when an element or layer is referred to as being "directly on", "directly connected to", "directly coupled to", or "immediately adjacent to" another element or layer, there are no intervening elements or layers present.

Any numerical range recited herein is intended to include all sub-ranges of the same numerical precision subsumed within the recited range. For example, a range of "1.0 to 10.0" or "between 1.0 and 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Similarly, a range described as "within 35% of 10" is intended to include all subranges between (and including) the recited minimum value of 6.5 (i.e., (1 - 35/100) times 10) and the recited maximum value of 13.5 (i.e., (1 + 35/100) times 10), that is, having a minimum value equal to or greater than 6.5 and a maximum value equal to or less than 13.5, such as, for example, 7.4 to 10.6. Any maximum numerical limitation recited herein is intended to include all lower numerical limitations subsumed therein and any minimum numerical limitation recited in this specification is intended to include all higher numerical limitations subsumed therein.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Some embodiments may include features of the following numbered statements.
1. A system, comprising:
   a phase-testing circuit, comprising:
      a difference-detecting circuit;
      a low-pass filter circuit; and
      a reference-comparison circuit,
   the difference-detecting circuit being configured to produce an output signal having a duty cycle corresponding to a phase difference between a first input signal, and a second input signal,
   the low-pass filter circuit being connected to an output of the difference-detecting circuit,
   the reference-comparison circuit being configured to compare an output signal of the low-pass filter circuit and a threshold.
2. The system of statement 1, wherein the threshold is set by a programmable voltage reference circuit.
3. The system of statement 2, wherein the programmable voltage reference circuit comprises a digital to analog converter.
4. The system of any one of the preceding statements, further comprising a first phase interpolator and a second phase interpolator, wherein the system is configured to calibrate the first phase interpolator by:
   setting a phase interpolator control signal of the first phase interpolator to a first value, and
   adjusting the threshold.
5. The system of any one of the preceding statements, wherein the difference-detecting circuit comprises:
   a first AND gate having:
      a first input configured to receive the first input signal, and
      a second input configured to receive the second input signal; and
   a second AND gate having:
      a first input configured to receive a third input signal, and
      a second input configured to receive a fourth input signal.
6. The system of statement 5, wherein the difference-detecting circuit comprises:
   a first switch, between an output of the first AND gate and the output of the difference-detecting circuit and
   a second switch, between an output of the second AND gate and the output of the difference-detecting circuit.
7. The system of statement 6, wherein the first switch is controlled by the output of the second AND gate, and the second switch is controlled by the output of the first AND gate.
8. The system of any one of the preceding statements, wherein:
   the difference-detecting circuit is configured to receive the first input signal through a first retiming circuit, and
   the difference-detecting circuit is configured to receive the second input signal through a second retiming circuit.
9. The system of any one of the preceding statements, wherein the reference-comparison circuit comprises a clocked comparator and a digital accumulator circuit.
10. The system of statement 9, wherein the clocked comparator is configured to generate an output corresponding to a comparison between the output of the low-pass filter circuit and the threshold.
11. The system of statement 9, wherein the digital accumulator circuit is configured to generate an output signal based on a plurality of bits received from the clocked comparator.
12. The system of any one of statements 9 to 11, wherein the digital accumulator circuit comprises:
   a first counter to count bits having a value of one;
   a second counter to count bits having value of zero; and
   an output circuit to generate a first output value based on the first counter reaching a threshold count or a second output value based on the second counter reaching a threshold count.
13. A method, comprising:
   setting a first phase interpolator control signal to a first value;
   determining, by a phase-testing circuit, that a phase difference between an output of a first phase interpolator and an output of a second phase interpolator exceeds a threshold;
   setting the first phase interpolator control signal to a second value;
   determining, by the phase-testing circuit, that a phase difference between the output of the first phase interpolator and the output of the second phase interpolator is less than the threshold; and
   storing, as a calibrated control signal value corresponding to the threshold, the first value or the second value.
14. The method of statement 13, wherein the phase-testing circuit comprises:
   a difference-detecting circuit;
   a low-pass filter circuit; and
   a reference-comparison circuit,
   the difference-detecting circuit being configured to produce an output signal having a duty cycle corresponding to a phase difference between a first input signal and a second input signal,
   the low-pass filter circuit being connected to the output of the difference-detecting circuit,
   the reference-comparison circuit being configured to compare an output signal of the low-pass filter circuit and a threshold.
15. The method of statement 13 or statement 14, wherein the threshold is set by a programmable voltage reference circuit.
16. The method of statement 15, wherein the programmable voltage reference circuit comprises a digital to analog converter.
17. The method of statement 14, wherein the difference-detecting circuit implements an exclusive OR truth table.
18. The method of any one of statements 14 to 17, wherein the difference-detecting circuit comprises:
   a first AND gate having:
      a first input configured to receive the first input signal, and
      a second input configured to receive the second input signal; and
   a second AND gate having:
      a first input configured to receive a third input signal, and
      a second input configured to receive a fourth input signal.
19. The method of statement 18, wherein the difference-detecting circuit comprises:
   a first switch, between the output of the first AND gate and the output of the difference-detecting circuit and
   a second switch, between the output of the second AND gate and the output of the difference-detecting circuit.
20. A method, comprising:
   determining, by a phase-testing circuit, that a phase difference between an output of a first phase interpolator and an output of a second phase interpolator exceeds a threshold,
   the phase-testing circuit comprising:
      a difference-detecting circuit;
      a low-pass filter circuit; and
      a reference-comparison circuit,
   the difference-detecting circuit being configured to produce an output signal having a duty cycle corresponding to a phase difference between a first input signal and a second input signal,
   the low-pass filter circuit being connected to the output of the difference-detecting circuit,
   the reference-comparison circuit being configured to compare an output signal of the low-pass filter circuit and a threshold.

Although exemplary embodiments of a phase calibrator have been specifically described and illustrated herein, many modifications and variations will be apparent to those skilled in the art. Accordingly, it is to be understood that a phase calibrator constructed according to principles of this disclosure may be embodied other than as specifically described herein. The invention is also defined in the following claims, and equivalents thereof.

## Claims

1. A system, comprising:
a phase-testing circuit, comprising:
a difference-detecting circuit;
a low-pass filter circuit; and
a reference-comparison circuit,
the difference-detecting circuit being configured to produce an output signal having a duty cycle corresponding to a phase difference between a first input signal, and a second input signal,
the low-pass filter circuit being connected to an output of the difference-detecting circuit,
the reference-comparison circuit being configured to compare an output signal of the low-pass filter circuit and a threshold.

2. The system of claim 1, wherein the threshold is set by a programmable voltage reference circuit.

3. The system of claim 2, wherein the programmable voltage reference circuit comprises a digital to analog converter.

4. The system of any one of claims 1 to 3, further comprising a first phase interpolator and a second phase interpolator, wherein the system is configured to calibrate the first phase interpolator by:
setting a phase interpolator control signal of the first phase interpolator to a first value, and
adjusting the threshold.

5. The system of any one of claims 1 to 4, wherein the difference-detecting circuit comprises:
a first AND gate having:
a first input configured to receive the first input signal, and
a second input configured to receive the second input signal; and
a second AND gate having:
a first input configured to receive a third input signal, and
a second input configured to receive a fourth input signal.

6. The system of claim 5, wherein the difference-detecting circuit comprises:
a first switch, between an output of the first AND gate and the output of the difference-detecting circuit and
a second switch, between an output of the second AND gate and the output of the difference-detecting circuit.

7. The system of claim 6, wherein the first switch is controlled by the output of the second AND gate, and the second switch is controlled by the output of the first AND gate.

8. The system of any one of claims 1 to 7, wherein:
the difference-detecting circuit is configured to receive the first input signal through a first retiming circuit, and
the difference-detecting circuit is configured to receive the second input signal through a second retiming circuit.

9. The system of any one of claims 1 to 8, wherein the reference-comparison circuit comprises a clocked comparator and a digital accumulator circuit.

10. The system of claim 9, wherein the clocked comparator is configured to generate an output corresponding to a comparison between the output of the low-pass filter circuit and the threshold.

11. The system of claim 9 or 10, wherein the digital accumulator circuit is configured to generate an output signal based on a plurality of bits received from the clocked comparator.

12. The system of claim 11, wherein the digital accumulator circuit comprises:
a first counter to count bits having a value of one;
a second counter to count bits having value of zero; and
an output circuit to generate a first output value based on the first counter reaching a threshold count or a second output value based on the second counter reaching a threshold count.

13. A method, comprising:
setting a first phase interpolator control signal to a first value;
determining, by a phase-testing circuit, that a phase difference between an output of a first phase interpolator and an output of a second phase interpolator exceeds a threshold;
setting the first phase interpolator control signal to a second value;
determining, by the phase-testing circuit, that a phase difference between the output of the first phase interpolator and the output of the second phase interpolator is less than the threshold; and
storing, as a calibrated control signal value corresponding to the threshold, the first value or the second value.

14. The method of claim 13, wherein the phase-testing circuit comprises:
a difference-detecting circuit;
a low-pass filter circuit; and
a reference-comparison circuit,
the difference-detecting circuit being configured to produce an output signal having a duty cycle corresponding to a phase difference between a first input signal and a second input signal,
the low-pass filter circuit being connected to the output of the difference-detecting circuit,
the reference-comparison circuit being configured to compare an output signal of the low-pass filter circuit and a threshold.

15. The method of claim 14, wherein the threshold is set by a programmable voltage reference circuit.
